# EUROPEAN PATENT APPLICATION

(11) **EP 4 764 571 A1**
(43) Date of publication of application: **24.06.2026**
(21) Application number: 25841385.5
(22) Date of filing: 14.07.2025
(51) Int. Cl.: G01R 31/396, G01R 31/382, G01R 31/392, G01R 19/10, G01R 19/165, G01R 19/30

(54) **BATTERY DIAGNOSIS DEVICE AND METHOD THEREOF**

(30) Priority: 19.07.2024 KR 20240095951
(71) Applicant: LG Energy Solution, Ltd., Seoul 07335 (KR)
(72) Inventor: CHOI, Yo Hwan, Daejeon 34122 (KR); SEO, Bo Kyung, Daejeon 34122 (KR)
(74) Representative: Plasseraud IP
(86) International application number: PCT/KR2025/010259
(87) International publication number: WO 2026/019184

(57) **Abstract**

A battery management device according to an embodiment of this document includes a memory configured to store at least one instruction and a processor configured to execute the at least one instruction, and the processor is configured to acquire incremental capacity data based on charging and discharging data for a plurality of battery cells, identify reference incremental capacity values of the plurality of battery cells corresponding to voltages of each of the plurality of battery cells using the incremental capacity data, and acquire a target voltage for diagnosing a state of the battery cell using the reference incremental capacity values.

## Description

### TECHNICAL FIELD

### Cross-reference to Related Applications

This application claims priority from Korean Patent Application No. 10-2024-0095951, filed on July 19, 2024, the disclosure of which is incorporated by reference herein.

### Technical Field

Embodiments disclosed in this document relate to a battery diagnosis device and battery diagnosis method.

### BACKGROUND ART

Recently, research and development on secondary batteries have been actively conducted. Here, secondary batteries are batteries that can be charged and discharged, and may be interpreted as including both conventional Ni/Cd batteries, Ni/MH batteries, and recent lithium-ion batteries. Recently, the scope of use of the secondary batteries has expanded to include a power source for electric vehicles, and the secondary batteries are attracting attention as a next-generation energy storage medium.

After completing an activation process for battery cells, the battery cells may be classified into normal cells and defective cells depending on whether the battery cells can output a designated voltage. Generally, in order to diagnose a battery cell, the battery cell was diagnosed by calculating a degree of self-discharge of the battery cell based on open circuit voltage (OCV) or measuring an internal leakage current of the battery cell. In this case, there was a problem that it took a lot of time and cost because a change in voltage was measured after storing the battery cell for a relatively long period of time.

### DISCLOSURE OF THE INVENTION

### TECHNICAL PROBLEM

Embodiments provide a battery diagnosis device and battery diagnosis method that acquire a target voltage for diagnosing a battery cell using incremental capacity data of a plurality of battery cells.

Embodiments provide a battery diagnosis device and battery diagnosis method that group a plurality of battery cells, acquire first incremental capacity values and second reference incremental capacity values, and acquire a target voltage for diagnosing the battery cell using the acquired first reference incremental capacity values and second reference incremental capacity values.

Embodiments provide a battery diagnosis device and battery diagnosis method that acquire a target voltage for diagnosing a battery cell using charging and discharging data of a plurality of battery cells.

The technical problems of the embodiments disclosed in this document are not limited to the technical problems mentioned above, and other technical problems that are not mentioned may be clearly understood by those skilled in the art from the descriptions below.

### TECHNICAL SOLUTION

A battery management device according to an embodiment of this document includes a memory configured to store at least one instruction and a processor configured to execute the at least one instruction, and the processor is configured to acquire incremental capacity data based on charging and discharging data for a plurality of battery cells, identify reference incremental capacity values of the plurality of battery cells corresponding to voltages of each of the plurality of battery cells using the incremental capacity data, and acquire a target voltage for diagnosing a state of the battery cell using the reference incremental capacity values.

In an embodiment, the processor may be configured to identify each of the voltages based on dividing a designated voltage range into designated voltage magnitudes, identify first reference incremental capacity values of a first portion of the plurality of battery cells that respectively correspond to the voltages among the reference incremental capacity values, and identify second reference incremental capacity values of a second portion of the plurality of battery cells that respectively correspond to the voltages among the reference incremental capacity values.

In an embodiment, the first reference incremental capacity value may include a representative value of incremental capacity values detected from the first portion that respectively correspond to the voltages, and the second reference incremental capacity value may include a representative value of incremental capacity values detected from the second portion that respectively correspond to the voltages.

In an embodiment, the processor may be configured to acquire the target voltage from among the voltages based on a difference between the first reference incremental capacity value and the second reference incremental capacity value.

In an embodiment, the processor may be configured to identify a voltage for which absolute value of the difference corresponds to a reference voltage as the target voltage.

In an embodiment, the reference voltage may include a largest voltage among the absolute values of the difference.

In an embodiment, the processor may be configured to acquire the target voltage based on sequentially aligning the difference.

In an embodiment, the processor may be configured to acquire the charging and discharging data based on performing a designated process on the battery pack.

A battery management device according to an embodiment of this document includes an operation of acquiring, by a processor, incremental capacity data based on charging and discharging data for a plurality of battery cells, an operation of identifying, by the processor, reference incremental capacity values of the plurality of battery cells corresponding to voltages of each of the plurality of battery cells using the incremental capacity data, and an operation of acquiring, by the processor, a target voltage for diagnosing a state of the battery cell using the reference incremental capacity values.

The battery management device according to an embodiment may include an operation of identifying each of the voltages based on dividing a designated voltage range into designated voltage magnitudes, an operation of identifying first reference incremental capacity values of a first portion of the plurality of battery cells that respectively correspond to the voltages among the reference incremental capacity values, and an operation of identifying second reference incremental capacity values of a second portion of the plurality of battery cells that respectively correspond to the voltages among the reference incremental capacity values.

In an embodiment, the first reference incremental capacity value may include a representative value of incremental capacity values detected from the first portion that respectively correspond to the voltages, and the second reference incremental capacity value may include a representative value of incremental capacity values detected from the second portion that respectively correspond to the voltages.

The battery management device according to an embodiment may include an operation of acquiring the target voltage from among the voltages based on a difference between the first reference incremental capacity value and the second reference incremental capacity value.

The battery management device according to an embodiment may include an operation of identifying a voltage for which absolute value of the difference corresponds to the reference voltage as the target voltage.

In an embodiment, the reference voltage may include the largest voltage among the absolute values of the difference.

The battery management device according to an embodiment may include an operation of acquiring the target voltage based on sequentially aligning the difference.

### ADVANTAGEOUS EFFECTS

The present technology can acquire a target voltage for diagnosing a battery cell using incremental capacity data of a plurality of battery cells.

In addition, the present technology can group a plurality of battery cells, acquire first incremental capacity values and second reference incremental capacity values, and acquire a target voltage for diagnosing the battery cell using the acquired first reference incremental capacity values and second reference incremental capacity values.

In addition, the present technology can acquire a target voltage for diagnosing a battery cell using charging and discharging data of a plurality of battery cells.

In addition, various effects directly or indirectly identified through this document may be provided.

### BRIEF DESCRIPTION OF THE DRAWINGS

FIG. 1 is a block diagram illustrating a battery pack, in a battery management device and battery management method according to an embodiment of this document.
FIG. 2 illustrates an example of a block diagram illustrating a configuration of a battery management device according to an embodiment of this document.
FIG. 3 illustrates an example of acquiring a target voltage using incremental capacity data, according to an embodiment of this document.
FIG. 4 illustrates an example of a graph related to incremental capacity data of battery cells, according to an embodiment of this document.
FIG. 5 illustrates an example of a graph representing a box plot related to a voltage of a battery cell, according to an embodiment of this document.
FIG. 6 illustrates an example of a flowchart related to a battery management method according to an embodiment of this document.
FIG. 7 is a block diagram illustrating a hardware configuration of a computing system that performs a battery management method, in a battery management device and battery management method according to an embodiment of this document.

### MODE FOR CARRYING OUT THE INVENTION

Hereinafter, some embodiments described in this document are described with reference to the accompanying drawings. However, this is not intended to limit the present technology to a specific embodiment, but should be understood to include various modifications, equivalents, and/or alternatives of the embodiments of the present technology.

When adding reference numerals to components in each drawing, it should be noted that the same components are given the same reference numerals as much as possible even if they are shown in different drawings. In addition, when describing various embodiments disclosed in this document, if a specific description of a related known configuration or function is determined to hinder understanding of the embodiments of the present disclosure, the detailed description thereof is omitted. A singular form of a noun corresponding to an item may include one item or a plurality of items unless the relevant context clearly indicates otherwise.

In describing the components of the embodiments of this document, terms such as first, second, A, B, (a), (b), etc. may be used. These terms are only intended to distinguish the components from other components, and the nature, order, or sequence of the components are not limited by the terms. In addition, unless otherwise defined, all terms used herein, including technical or scientific terms, have the same meaning as generally understood by a person having ordinary skill in the art to which the embodiments disclosed in this document belong. Terms defined in commonly used dictionaries should be interpreted as having a meaning consistent with the meaning they have in the context of the relevant technology, and shall not be interpreted in an ideal or excessively formal sense unless explicitly defined in this application.

In addition, in the present disclosure, expressions of "more than" or "less than" may be used to determine whether a specific condition is satisfied or fulfilled, but this is only a description for expressing an example and does not exclude descriptions of "greater than or equal to" or "less than or equal to". A condition described as "greater than or equal to" may be replaced with "more than", a condition described as "less than or equal to" may be replaced with "less than", and a condition described as "greater than or equal to and less than" may be replaced with "more than and less than or equal to". In addition, hereinafter, "A" to "B" mean at least one of the elements from A (including A) to B (including B).

In this document, each of phrases "A or B", "at least one of A and B", "at least one of A or B", "A, B, or C", "at least one of A, B, and C", and "at least one of A, B, or C" may include any one of the items listed together in the corresponding phrase among the phrases, or all possible combinations thereof.

In this document, when a component (e.g., a first component) is referred to as being "connected", "coupled" or "joined" to another component (e.g., a second component), with or without the terms "functionally" or "communicatively", it means that the component can be connected to the other component directly (e.g., in a wired manner), wirelessly, or through a third component.

The method according to the various embodiments disclosed in this document may be provided by being included in a computer program product. The computer program product may be traded between a seller and a buyer as a product. The computer program product may be distributed in the form of a machine-readable recording medium (e.g., compact disc read only memory (CD-ROM)), or distributed through an application store, distributed directly between two user devices, or distributed online (e.g., downloaded or uploaded). In the case of online distribution, at least a part of the computer program product may be temporarily stored or temporarily generated in a machine-readable recording medium, such as a memory of a manufacturer's server, an application store's server, or a relay server.

According to various embodiments, each of the components (e.g., modules or programs) described above may include a single or plurality of entities, and some of the plurality of entities may be separated and placed in other components. According to various embodiments, one or more of the components or operations described above may be omitted, or one or more other components or operations may be added. Alternatively or additionally, a plurality of components (e.g., modules or programs) may be integrated into a single component. In such a case, the integrated component may perform one or more functions of each of the plurality of components identically or similarly to those performed by the corresponding component among the plurality of components prior to the integration. According to various embodiments, the operations performed by a module, program, or other component may be performed sequentially, in parallel, repeatedly, or heuristically, or one or more of the operations may be performed in a different order, omitted, or performed by adding one or more other operations.

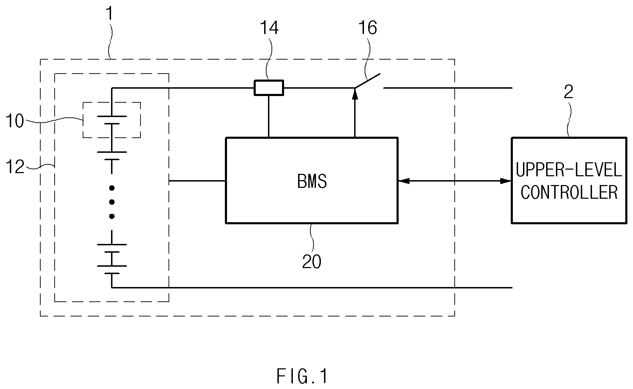

Hereinafter, embodiments of this document will be described in detail with reference to FIGS. 1 to 7.

FIG. 1 is a block diagram showing a battery pack, in a battery diagnosis device and battery diagnosis method according to an embodiment of this document.

Referring to FIG. 1, a battery pack 1 may include a battery unit 12, a sensor unit 14, a switching unit 16, and a battery management system (BMS) 20. In this case, the battery pack 1 may be equipped with a plurality of battery units 12, sensor units 14, switching units 16, and battery management systems 20.

According to an embodiment, the battery unit 12 may supply power to a target device (not shown). To this end, the battery unit 12 may be electrically connected to the target device. Here, the target device may include an electrical, electronic, or mechanical device that operates by receiving power from the battery pack 1. For example, the target device may be, but is not limited to, an electric vehicle (EV).

According to an embodiment, the battery unit 12 may include at least one battery unit 10 that is chargeable and dischargeable. Here, the battery cell 10 may be a basic unit of a battery cell that can be used by charging and discharging electric energy. For example, the battery cell 10 may be a lithium-ion (Li-ion) battery, a lithium-ion polymer battery, a nickel-cadmium (Ni-Cd) battery, a nickel-metal hydride (Ni-MH) battery, etc., but is not limited thereto.

According to an embodiment, a plurality of battery units 12 may be connected in series or in parallel. For example, the battery unit 12 may be a battery module, a battery bank, or a set of battery cells (cell-to-pack structure).

According to an embodiment, the sensor unit 14 may acquire information related to the battery unit 12. According to an embodiment, the sensor unit 14 may acquire values (or information) related to a state of each of the battery units 12 or battery cells 10. In an embodiment, the values related to the state may include one or more values for a voltage, a current, a resistance, a state of charge (SOC), a state of health (SOH), or a temperature of the battery cell, or a combination thereof.

According to an embodiment, the sensor unit 14 may provide information on each of the plurality of battery units 12 to the battery management system 20.

According to an embodiment, the switching unit 16 may include a device for controlling a current flow for charging or discharging the battery unit 12. For example, the switching unit 16 may include at least one relay and/or magnetic contactor, etc., depending on the specifications of the battery pack 1.

According to an embodiment, the battery management system (BMS) 20 may control or manage the battery pack 1 to prevent overcharge and overdischarge, etc. by monitoring the voltage, current, temperature, etc. of the battery pack 1. For example, the battery management system 20 is an interface that receives values acquired by measuring various parameters described above, and may include a plurality of terminals, a circuit connected to these terminals to process the received values, etc. In addition, the battery management system 20 may control the sensor unit 14 and/or the switching unit 16. For example, the battery management system 20 may be connected to a plurality of battery units including the battery unit 12 to monitor the state of each of the plurality of battery units 12 and control ON/OFF of a relay or contactor, etc.

According to an embodiment, an operation of the battery management system 20 may be performed by a battery management system (BMS) in a vehicle, and may also be performed in various devices such as a server, a cloud, a charger, or a charger/discharger.

An upper-level controller 2 may transmit a control signal for the plurality of battery units 12 to the battery management system 20. Accordingly, the operation of the battery management system 20 may be controlled based on a signal applied from the upper-level controller 2.

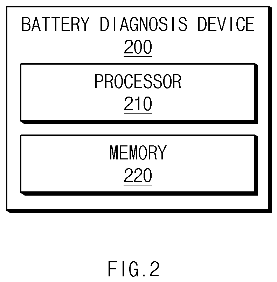

According to an embodiment, the battery management system 20 may include a battery diagnosis device 200 of FIG. 2. According to another embodiment, the battery management system 20 may be a different system from the battery diagnosis device 200 of FIG. 2. That is, the battery diagnosis device 200 of FIG. 2 may be included in the battery pack 1 or may be configured as another device external to the battery pack 1. Hereinafter, for convenience of description, the description will be made on the assumption that the battery diagnosis device 200 is composed of another device external to the battery pack 1. In addition, the operation of the battery diagnosis device 200 described below may be performed by a BMS in the vehicle, and may also be performed by various devices such as a server, a cloud, a charger, or a discharger.

FIG. 2 illustrates an example of a block diagram illustrating the configuration of a battery diagnosis device according to an embodiment of this document.

Referring to FIG. 2, the battery diagnosis device 200 according to an embodiment may include a processor 210 and a memory 220. The processor 210 and the memory 220 may be electrically and/or operably coupled with each other by an electronic component including a communication bus.

Hereinafter, operably coupling pieces of hardware with each other may include a direct connection and/or an indirect connection between pieces of hardware being established in a wired manner and/or wirelessly, such that a second piece of hardware is controlled by a first piece of hardware among the pieces of hardware.

Although pieces of hardware are illustrated in different blocks, embodiments are not limited thereto. For example, some of the pieces of hardware of FIG. 2 may be included in a single integrated circuit including a system on a chip (SoC). The type and/or number of pieces of hardware included in the battery management device 200 is not limited to that shown in FIG. 2. For example, the battery management device 200 may include only some pieces of the hardware shown in FIG. 2.

The battery management device 200 according to an embodiment may include hardware for processing data based on one or more instructions. The hardware for processing data may include the processor 210. For example, hardware for processing data may include an arithmetic and logic unit (ALU), a floating point unit (FPU), a field programmable gate array (FPGA), a central processing unit (CPU), and/or an application processor (AP).

For example, the processor 210 may have a single-core processor architecture or a multi-core processor architecture having dual cores, quad cores, hexa cores, or octa cores.

The memory 220 of the battery management device 200 according to an embodiment may include hardware components for storing data and/or instructions input and/or output to and from the processor 210 of the battery management device 200.

For example, the memory 220 may include a volatile memory including random-access memory (RAM) and/or a non-volatile memory including a read-only memory (ROM).

For example, the volatile memory may include at least one of dynamic RAM (DRAM), static RAM (SRAM), cache RAM, pseudo-SRAM (PSRAM), or any combination thereof.

For example, the non-volatile memory may include at least one of programmable ROM (PROM), erasable PROM (EPROM), electrically erasable PROM (EEPROM), flash memory, a hard disk, a compact disc, a solid state drive (SSD), an embedded multi-media card (eMMC), or any combination thereof.

For example, at least one instruction (or command) indicating operations and/or actions to be performed on data by the processor 210 of the battery management device 200 may be stored in the memory 220 of the battery management device 200.

For example, a set of at least one instruction may be referred to as a program, firmware, operating system, process, routine, subroutine, and/or application. Hereinafter, the installation of an application in the battery management device 200 may mean that at least one instruction provided in the form of an application is stored in the memory 220, and that the is stored in an executable format (e.g., a file having an extension designated by an operating system of the battery management device 200 by the processor 210 of the battery management device 200.

The battery diagnosis device 200 according to an embodiment may include the processor 210 that executes at least one instruction and the memory 220 that stores at least one instruction.

In an embodiment, the processor 210 may acquire charging and discharging data for a plurality of battery cells including battery cells 10 included in the battery pack 1 and/or the battery unit 12. For example, the processor 210 may acquire incremental capacity data based on acquiring the charging and discharging data for the plurality of battery cells included in the battery pack. Hereinafter, the plurality of battery cells may be understood to include the battery cell 10 of FIG. 1. In addition, the battery pack 1 below may include the battery unit 12.

For example, the charging and discharging data may include at least one of the voltage of the battery pack 1, the current of the battery pack 1, the time, the capacity of the battery pack 1, or any combination thereof. For example, the charging and discharging data may include at least one of the voltage of the battery cell 10, the current of the battery cell 10, the time, the capacity of the battery cell 10, or any combination thereof.

For example, the processor 210 may acquire incremental capacity data based on preprocessing of the charging and discharging data for a plurality of battery cells included in the battery pack 1. For example, preprocessing may include acquiring incremental capacity data using the charging and discharging data. For example, preprocessing may include extracting features from the charging and discharging data.

For example, the processor 210 may acquire charging and discharging data based on performing a designated process on the battery pack 1. For example, the designated process may include a process performed by the battery diagnosis device 200 or an external electronic device different from the battery diagnosis device 200. For example, the charging and discharging data may be acquired based on performing charge and discharge on the battery pack 1. For example, charging and discharging data may be acquired based on performing charge and discharge on the battery cell 10. For example, charging and discharging data may be acquired based on performing charge and discharge on the battery unit 12.

For example, the designated process may include an activation process. For example, the activation process may include a first operation that performs aging on the battery, a second operation that performs charging and discharging of the battery, and a third operation that performs degassing for removing internal gas from the battery. For example, the activation process may include a process that repeatedly performs the first operation, the second operation, and the third operation.

In an embodiment, the processor 210 may identify reference incremental capacity values of a plurality of battery cells that respectively correspond to the plurality of battery cells based on incremental capacity data.

For example, the processor 210 may divide a designated voltage range into designated voltage magnitudes. For example, the processor 210 may identify each of the voltages the plurality of battery cells. For example, the processor 210 may identify each of the voltages of the plurality of battery based on dividing a designated voltage range into designated voltage magnitudes.

For example, the processor 210 may identify first reference incremental capacity values of a first portion of the plurality of battery cells corresponding to each of the voltages of the plurality of battery cells among the reference incremental capacity values. For example, the first portion of the plurality of battery cells may include defective cells. For example, defective cells may include battery cells have a relatively lower voltage than normal cells to be described below. For example, defective cells may include battery cells that can output a voltage lower than a voltage in a designated range. For example, defective cells may include battery cells that can output a voltage in a range different from the designated range. For example, defective cells may include battery cells that can output a voltage outside the designated range. For example, defective cells may include battery cells that can output a voltage lower than the minimum voltage within the designated range.

For example, the first reference incremental capacity value may include a representative value of the incremental capacity values detected from a first portion of the plurality of battery cells corresponding to each of the voltages of the plurality of battery cells.

For example, the processor 210 may identify second reference incremental capacity values of a second portion of the plurality of battery cells corresponding to each of the voltages of the plurality of battery cells among the reference incremental capacity values. For example, the second portion of the plurality of battery cells may include normal cells. For example, the normal cells may include battery cells that can output a voltage within a designated range. For example, the normal cells may include battery cells that can output a voltage within a designated range.

For example, the second reference incremental capacity value may include a representative value of the incremental capacity value detected from a second portion of the plurality of battery cells corresponding to each of the voltages of the plurality of battery cells.

The representative value described above may include at least one of an average value, an intermediate value, an arithmetic average value, a geometric average value, a harmonic average value, a weighted average value, a median value, a mode value, a maximum value, a minimum value, a quartile, or a combination thereof). However, examples of the representative value are not limited to those described above. Hereinafter, for convenience of description, a representative value will be described as an average value instead of the representative value.

In an embodiment, the processor 210 may acquire a target voltage for diagnosing a state of at least one of the battery pack 1, the battery unit 12, the battery cell 10, or any combination thereof, based on reference incremental capacitance values.

For example, the processor 210 may acquire the target voltage from among the voltages of the plurality of battery cells. For example, the processor 210 may acquire the target voltage from among the voltages of the plurality of battery cells based on a difference between a first reference incremental capacitance value and a second reference incremental capacitance value.

For example, the processor 210 may identify an absolute value of the difference between the first reference incremental capacitance value and the second reference incremental capacitance value.

For example, the processor 210 may identify whether the absolute value of the difference between the first reference incremental capacitance value and the second reference incremental capacitance value corresponds to a reference voltage. For example, the processor 210 may identify a voltage for which the absolute value of the difference between the first reference incremental capacitance value and the second reference incremental capacitance value corresponds to the reference voltage. For example, the processor 210 may identify the voltage for which the absolute value of the difference between the first reference incremental capacitance value and the second reference incremental capacitance value corresponds to the reference voltage as the target voltage.

For example, the reference voltage may include the largest voltage among the absolute values of the differences between the first reference incremental capacitance value and the second reference incremental capacitance value.

For example, the processor 210 may sequentially align the difference between the first reference incremental capacitance value and the second reference incremental capacitance value. For example, the processor 210 may acquire a target voltage based on sequentially aligning the difference between the first reference incremental capacitance value and the second reference incremental capacitance value.

For example, the processor 210 may acquire a target voltage by identifying a voltage having the largest difference between the first reference incremental capacity value and the second reference incremental capacity value based on sequentially aligning the difference between the first reference incremental capacity value and the second reference incremental capacity value.

In an embodiment, the processor 210 may identify a target range including the target voltage. For example, the target range may include a voltage for diagnosing battery cells. For example, the target range may include a voltage range for determining whether each of the battery cells is a normal cell or defective cell.

According to an embodiment, the battery diagnosis device 200 may diagnose the battery cell 10 using the target voltage. However, the embodiment is not limited thereto. For example, an external electronic device different from the battery diagnosis device 200 may diagnose the battery cell using the target voltage. For example, the battery diagnosis device 200 may provide the target voltage to the external electronic device. For example, in order for an external electronic device to diagnose a battery cell using a target voltage, the battery diagnosis device 200 may transmit data (or information) including the target voltage to the external electronic device through a communication circuit.

For example, the battery cell 10 that outputs a voltage lower than the target voltage may be a defective cell, and the battery cell 10 that outputs a voltage higher than the target voltage may be a normal cell.

For example, the battery diagnosis device 200 may diagnose a battery cell 10 whose voltage is lower than the target voltage as a defective cell. For example, the battery diagnosis device 200 may diagnose the battery cell 10 whose voltage is higher than the target voltage as a normal cell.

As described above, the battery diagnosis device 200 according to an embodiment may acquire a target voltage for diagnosing the battery cell 10 based on incremental capacity data of the battery pack 1. The battery diagnosis device 200 and/or external electronic device may accurately diagnose whether the battery cell 10 is a normal cell or a defective cell by diagnosing the battery cell 10 using the target voltage.

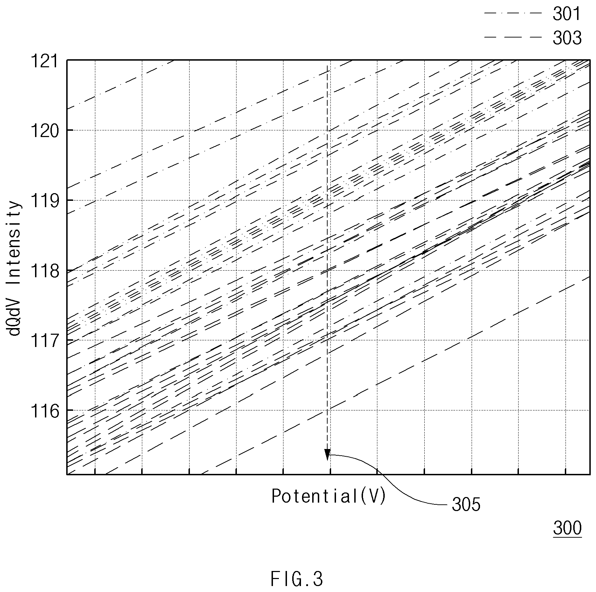

FIG. 3 illustrates an example of acquiring a target voltage using incremental capacity data according to an embodiment of this document.

Referring to FIG. 3, the processor 210 of the battery diagnosis device 200 according to an embodiment may acquire a graph 300 including incremental capacity data.

For example, the processor 210 may acquire the graph 300 including the incremental capacity data based on charging and discharging data of a plurality of battery cells. For example, the processor 210 may identify reference incremental capacity values of a plurality of battery cells that respectively correspond to the voltages of the plurality of battery cells using the incremental capacity data.

For example, the processor 210 may acquire first reference incremental capacity values 301 of a first portion of the plurality of battery cells that respectively correspond to the voltages of the plurality of battery cells among the reference incremental capacity values.

For example, the processor 210 may acquire second reference incremental capacity values 303 of a second portion of the plurality of battery cells that respectively correspond to the voltages of the plurality of battery cells among the reference incremental capacity values.

For example, the first portion may include defective cells. For example, the second portion may include normal cells.

For example, the processor 210 may identify the differences between the first reference incremental capacitance values 301 and the second reference incremental capacitance values 303. For example, the processor 210 may identify absolute values of the differences between the first reference incremental capacitance values 301 and the second reference incremental capacitance values 303.

For example, the processor 210 may identify the voltage having the largest absolute value of the absolute values of the differences between the first reference incremental capacitance values 301 and the second reference incremental capacitance values 303. For example, the processor 210 may identify the voltage having the largest absolute value of the absolute values of the differences between the first reference incremental capacity values 301 and the second reference incremental capacity values 303 as the target voltage 305.

For example, the battery diagnosis device 200 may diagnose the battery pack 1, battery cell 10, and/or battery unit 12 based on the target voltage 305 identified using the graph 300 and/or incremental capacity data.

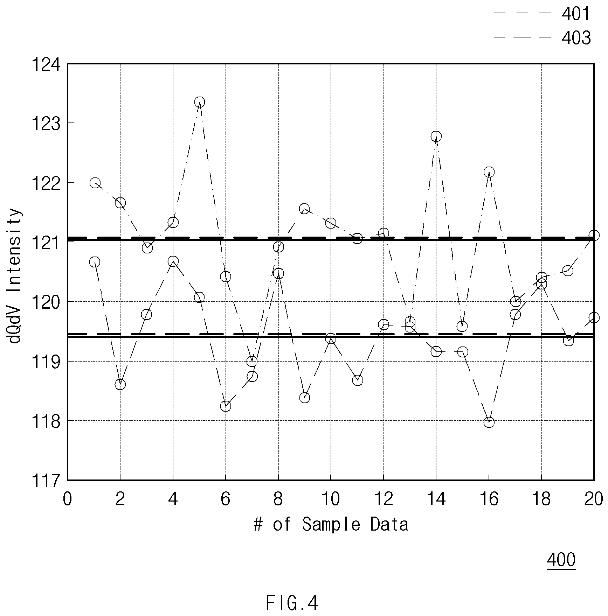

FIG. 4 illustrates an example of a graph related to incremental capacity data of battery cells in an embodiment of this document.

Referring to FIG. 4, the battery diagnosis device 200 and/or an external electronic device diagnosing the battery cell 10 according to an embodiment may diagnose the battery cell 10 using the target voltage acquired through FIGS. 1 to 3.

For example, the battery diagnosis device 200 and/or the external electronic device may acquire a graph 400 based on the diagnosis of the battery cell. For example, in the graph 400, first result values 401 may include incremental capacity values acquired from defective cells. For example, second result values 403 may include incremental capacity values acquired from normal cells.

Looking at the graph 400, a difference between the average value and/or the intermediate value of the first result values 401 and the average value and/or the intermediate value of the second result values 403 may be confirmed. The battery diagnosis device 200 and/or the external electronic device may distinguish normal cells from defective cells, as shown in the graph 400, by diagnosing the battery cell 10 using the target voltage.

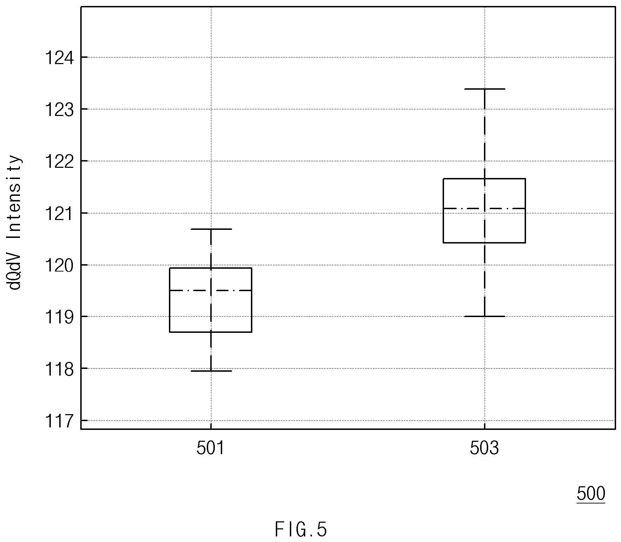

FIG. 5 illustrates an example of a graph representing a box plot related to the voltage of a battery cell according to an embodiment of this document.

Referring to FIG. 5, the battery diagnosis device 200 and/or an external electronic device for diagnosing the battery cell 10 may acquire a graph 500 based on the diagnosis of the battery cell 10 using the target voltage.

For example, the graph 500 may be an example representing a box plot of battery cells. In the graph 500, a first result 501 may include an example representing a box plot of a normal cell. In the graph 500, a second result 503 may include an example representing a box plot of a defective cell.

Looking at the graph 500, it can be confirmed that the first quartile of the first result 501 and the first quartile of the second result 503 do not overlap. Looking at the graph 500, it can be confirmed that the second quartile of the first result 501 and the second quartile of the second result 503 do not overlap. Looking at the graph 500, it can be confirmed that the third quartile of the first result 501 and the third quartile of the second result do not overlap.

The battery diagnosis device 200 according to an embodiment and/or the external electronic device may clearly distinguish between normal and defective cells, as shown in graph 500 by diagnosing the battery cell 10 using the target voltage.

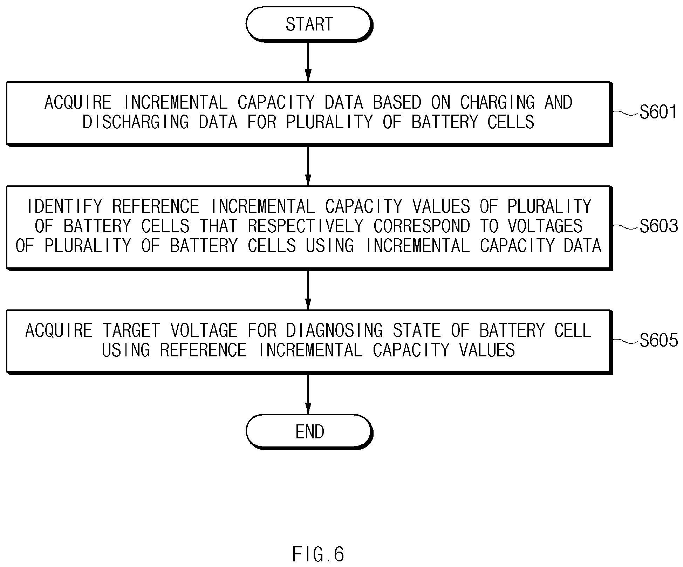

FIG. 6 illustrates an example flowchart related to a battery diagnosis method according to an embodiment of this document.

Hereinafter, it is assumed that the battery diagnosis device 200 of FIG. 2 performs the process of FIG. 6. In addition, in the description of FIG. 6, the operations described as being performed by the device may be understood as being controlled by the processor 210 of the battery diagnosis device 200.

At least one of the operations of FIG. 6 may be performed by the battery diagnosis device 200 of FIG. 2. At least one of the operations of FIG. 6 may be controlled by the processor 210 of FIG. 2. Each of the operations of FIG. 6 may be performed sequentially, but is not necessarily performed sequentially. For example, the order of each of the operations may be changed, and at least two operations may be performed in parallel.

Referring to FIG. 6, in operation S601, the battery diagnosis method according to an embodiment may include an operation of acquiring incremental capacity data based on charging and discharging data for a plurality of battery cells included in the battery pack 1.

For example, the battery diagnosis method may include an operation of acquiring incremental capacity data based on charging and discharging data for the battery cell 10 included in at least one of the battery pack 1, the battery unit 12, or any combination thereof.

For example, the battery diagnosis method may include an operation of acquiring charging and discharging data based on performing a designated process on the battery pack 1.

In operation S603, the battery diagnosis method according to an embodiment may include an operation of identifying reference incremental capacity values of a plurality of battery cells that respectively correspond to the voltages of the plurality of battery cells using the incremental capacity data.

For example, the battery diagnosis method may include an operation of identifying each of the voltages of the plurality of battery cells based on dividing the designated voltage range into designated voltage magnitudes.

For example, the battery diagnosis method may include an operation of identifying first reference incremental capacity values of a first portion of the plurality of battery cells corresponding to each of the voltages of the plurality of battery cells among the reference incremental capacity values.

For example, the battery diagnosis method may include an operation of identifying second reference incremental capacity values of a second portion of the plurality of battery cells corresponding to each of the voltages of the plurality of battery cells among the reference incremental capacity values.

For example, the first reference incremental capacity value may include an average value of incremental capacity values detected from the first portion that respectively correspond to the voltages of the plurality of battery cells.

For example, the second reference incremental capacity value may include the average value of incremental capacity values detected from the second portion corresponding to each of the voltages of the plurality of battery cells.

In operation S605, the battery diagnosis method according to an embodiment may include an operation of acquiring a target voltage for diagnosing a state of the battery cell 10 using the reference incremental capacity values.

For example, the battery diagnosis method may include an operation of acquiring a target voltage for diagnosing the state of at least one of the battery pack 1, the battery unit 12, the battery cell 10, or any combination thereof using the reference incremental capacity values.

For example, the battery diagnosis method may include an operation of acquiring a target voltage based on a difference between a first reference incremental capacity value and a second reference incremental capacity value among the voltages of a plurality of battery cells.

For example, the battery diagnosis method may include an operation of identifying a voltage, for which the absolute value of the difference between the first reference incremental capacity value and the second reference incremental capacity value corresponds to the reference voltage, as the target voltage.

For example, the reference voltage may include the voltage having the largest absolute value among the differences between the first reference incremental capacity value and the second reference incremental capacity value. For example, the reference voltage may include the voltage for which the absolute value corresponds to the largest value.

For example, the battery diagnosis method may include an operation of acquiring a target voltage based on sequentially aligning the difference between the first reference differential capacity value and the second reference differential capacity value.

In this document, it has been described that the battery diagnosis device 200 and/or battery diagnosis method acquires a target voltage for diagnosing the status of the battery pack 1, the battery unit 12, and/or the battery cell 10, but the embodiments are not limited thereto. For example, the battery diagnosis device 200 and/or battery diagnosis method may diagnose the state of a battery pack, battery unit, and/or battery cell different from the battery pack 1, the battery unit 12, and/or the battery cell 10 based on the acquisition of the target voltage.

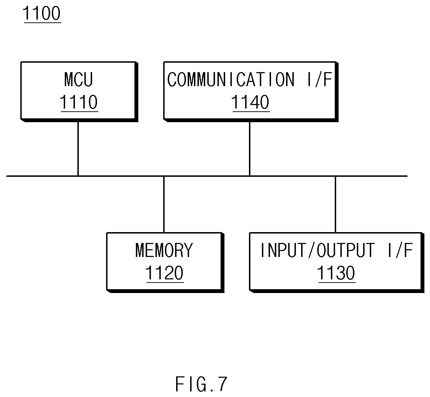

FIG. 7 is a block diagram illustrating a hardware configuration of a computing system that performs a battery diagnosis method, in a battery diagnosis device and battery diagnosis method according to an embodiment of this document.

Referring to FIG. 7, a computing system 1100 according to an embodiment disclosed in this document may include an MCU 1110, a memory 1120, an input/output I/F 1130, and a communication I/F 1140.

The MCU 1110 may be a processor that executes various programs (e.g., battery cell data collection program, graph generation program, data analysis program, data decomposition algorithm, normalization program, and battery cell diagnosis program, etc.) stored in the memory 1220, processes various information including characteristic data of the battery cell, latent variables, etc. through these programs, and performs the functions of the battery diagnosis device 200 shown in FIGS. 1 to 7 described above.

The memory 1120 may store various programs such as the battery cell data collection program, the graph generation program, the data analysis program, the data decomposition algorithm, the normalization program, and the battery cell diagnosis program.

A plurality of such memories 1120 may be provided as needed. The memory 1120 may be a volatile memory or a nonvolatile memory. The memory 1120 used as the volatile memory may be RAM, DRAM, SRAM, etc. The memory 1120 used as the nonvolatile memory may be ROM, PROM, EAROM, EPROM, EEPROM, flash memory, etc. The examples of the memories 1120 listed above are only examples, but are not limited to these examples.

The input/output I/F 1130 may provide an interface that allows data to be transmitted and received by connecting an input device (not shown) such as a keyboard, mouse, or touch panel and an output device (not shown) such as a display with the MCU 1110.

The communication I/F 1140 is a configuration that can transmit and receive various data with the server, and may be various devices that can support wired or wireless communication. For example, the battery diagnosis device 200 may transmit and receive various information including shape models of battery cells, etc. to and from a separately provided external server through the communication I/F 1140.

In this way, the computer program according to an embodiment disclosed in this document may be implemented as a module that performs, for example, each function shown in FIG. 2, by being recorded in the memory 1120 and processed by the MCU 1110.

In the above, even though all the components constituting the embodiments disclosed in this document have been described as being combined as one or operating in combination, the embodiments disclosed in this document are not necessarily limited to such embodiments. That is, within the scope of the purpose of the embodiments disclosed in this document, all of the components may be selectively combined and operated in one or more combinations.

In addition, the terms "include," "configure," or "have" described above, unless specifically stated to the contrary, mean that the corresponding component may be included, and therefore should be interpreted as being able to further include other components rather than excluding other components. All terms including technical or scientific terms have the same meaning as commonly understood by a person skilled in the art to which the embodiments disclosed in this document belong, unless otherwise defined. Terms commonly used, such as terms defined in the dictionary, should be interpreted as being consistent with the contextual meaning of the relevant technology, and should not be interpreted in an idealized or overly formal sense unless clearly defined in this document.

The above-mentioned disclosure outlines the features of several embodiments so that those skilled in the art may better understand aspects of the present disclosure. Those skilled in the art will understand that the present disclosure may be easily used as a basis for designing or changing different structures to perform the same purpose or achieve the same advantages of embodiments introduced in this document. Furthermore, those skilled in the art will recognize that such equivalent configurations do not depart from the scope of the present disclosure, and that various changes, substitutions, and modifications may be made in this specification without departing from the scope of the present disclosure.

## Claims

1. A battery diagnosis device, comprising:
a memory configured to store at least one instruction; and
at least one processor configured to execute the at least one instruction,
wherein the at least one processor is configured to:
acquire incremental capacity data based on charging and discharging data for a plurality of battery cells;
identify reference incremental capacity values of the plurality of battery cells corresponding to voltages of each of the plurality of battery cells using the incremental capacity data; and
acquire a target voltage for diagnosing a state of the battery cell using the reference incremental capacity values.

2. The battery diagnosis device of claim 1, wherein the processor is configured to:
identify each of the voltages based on dividing a designated voltage range into designated voltage magnitudes;
identify first reference incremental capacity values of a first portion of the plurality of battery cells that respectively correspond to the voltages among the reference incremental capacity values; and
identify second reference incremental capacity values of a second portion of the plurality of battery cells that respectively correspond to the voltages among the reference incremental capacity values.

3. The battery diagnosis device of claim 2, wherein the first reference incremental capacity value includes a representative value of incremental capacity values that respectively correspond to the voltages, and
the second reference incremental capacity value includes a representative value of incremental capacity values detected from the second portion that respectively correspond to the voltages.

4. The battery diagnosis device of claim 2, wherein the processor is configured to acquire the target voltage from among the voltages based on a difference between the first reference incremental capacity value and the second reference incremental capacity value.

5. The battery diagnosis device of claim 4, wherein the processor is configured to identify a voltage for which absolute value of the difference corresponds to a reference voltage as the target voltage.

6. The battery diagnosis device of claim 5, wherein the reference voltage includes a largest voltage among the absolute values of the difference.

7. The battery diagnosis device of claim 4, wherein the processor is configured to acquire the target voltage based on sequentially aligning the difference.

8. The battery diagnosis device of claim 1, wherein the processor is configured to acquire the charging and discharging data based on performing a designated process on the battery pack.

9. A battery diagnosis method comprising:
an operation of acquiring, by a processor, incremental capacity data based on charging and discharging data for a plurality of battery cells;
an operation of identifying, by the processor, reference incremental capacity values of the plurality of battery cells corresponding to voltages of each of the plurality of battery cells using the incremental capacity data; and
an operation of acquiring, by the processor, a target voltage for diagnosing a state of the battery cell using the reference incremental capacity values.

10. The battery diagnosis method of claim 9, further comprising:
an operation of identifying each of the voltages based on dividing a designated voltage range into designated voltage magnitudes;
an operation of identifying first reference incremental capacity values of a first portion of the plurality of battery cells that respectively correspond to the voltages among the reference incremental capacity values; and
an operation of identifying second reference incremental capacity values of a second portion of the plurality of battery cells that respectively correspond to the voltages among the reference incremental capacity values.

11. The battery diagnosis method of claim 10, wherein the first reference incremental capacity value includes a representative value of incremental capacity detected from the first portion that respectively correspond to the voltages, and
the second reference incremental capacity value includes a representative value of incremental capacity values detected from the second portion that respectively correspond to the voltages.

12. The battery diagnosis method of claim 10, further comprising:
an operation of acquiring the target voltage from among the voltages based on a difference between the first reference incremental capacity value and the second reference incremental capacity value.

13. The battery diagnosis method of claim 12, further comprising:
an operation of identifying a voltage for which absolute value of the difference corresponds to the reference voltage as the target voltage.

14. The battery diagnosis method of claim 13, wherein the reference voltage includes the largest voltage among the absolute values of the difference.

15. The battery diagnosis method of claim 13, further comprising:
an operation of acquiring the target voltage based on sequentially aligning the difference.
